# EUROPÄISCHE PATENTSCHRIFT

(11) **EP 3 776 858 B1**
(45) Veröffentlichungstag und Bekanntmachung des Hinweises auf die Patenterteilung: **02.03.2022**
(21) Anmeldenummer: 19715028.7
(22) Anmeldetag: 27.03.2019
(51) Int. Cl.: H03K 17/605, H03K 17/689, H04L 25/02, H03F 3/45

(54) **DETEKTORSCHALTUNG UND SYSTEM ZUR GALVANISCH-GETRENNTEN ÜBERTRAGUNG DIGITALER SIGNALE**
DETECTOR CIRCUIT AND SYSTEM FOR THE GALVANICALLY ISOLATED TRANSMISSION OF DIGITAL SIGNALS
CIRCUIT DÉTECTEUR ET SYSTÈME DE TRANSMISSION AVEC SÉPARATION GALVANIQUE DE SIGNAUX NUMÉRIQUES

(30) Priorität: 28.03.2018 DE 102018204782
(43) Veröffentlichungstag der Anmeldung: 17.02.2021
(73) Patentinhaber: Robert Bosch GmbH, 70442 Stuttgart (DE)
(72) Erfinder: SCHUBERT, Andreas, 01640 Coswig (DE)
(86) Internationale Anmeldenummer: PCT/EP2019/057663
(87) Internationale Veröffentlichungsnummer: WO 2019/185677

(56) Entgegenhaltungen:
- WO-A1-2006/066167
- WO-A1-2016/191851

## Beschreibung

Die vorliegende Erfindung betrifft eine Detektorschaltung zur galvanisch-getrennten Übertragung digitaler Signale sowie ein System zur galvanisch-getrennten Übertragung digitaler Signale umfassend eine solche Detektorschaltung.

### Stand der Technik

Die Notwendigkeit zur galvanisch getrennten Signalübertragung besteht für Systeme, in denen die zwischen einzelnen Teilen des Systems auftretenden Spannungen das System oder Teile davon beschädigen können und damit auch eine potenzielle Gefahr für den Nutzer darstellen. Alltägliche Beispiele dafür sind Steuerungen für elektronisch kommutierte Motoren, geschaltete Spannungswandler oder Synchrongleichrichter für Spannungen, die viel größer sind (> 500 V) als die in der Signalverarbeitung üblichen Spannungen von bis zu 5 V. Zunehmend an Bedeutung gewinnt derzeit der Einsatz in modernen Elektroantrieben und in der Elektroenergieübertragung.

Das Dokument WO 2016/191851 offenbart Systeme und Verfahren für spektraleffizienten und energieeffizienten Ultra-Breitband-Impulsfunk und skalierbare Datenraten.

Das Dokument WO 2006/066167 A1 beschreibt eine Empfängerentzerrung mit geringem Stromverbrauch in einem getakteten Verstärker.

Im Stand der Technik gibt es verschiedene grundlegende Isolator-Prinzipien.

Optische Isolatoren gibt es seit den 1960er Jahren. Eine steuerbare Lichtquelle - in der Regel eine LED - stimuliert ein lichtempfindliches Bauelement, das als Empfänger dient. Dabei sind Sender (Lichtquelle, zum Beispiel eine LED) und Empfänger (zum Beispiel ein Phototransistor) voneinander galvanisch getrennt. Dieses Konzept ist sehr einfach und ermöglicht die Übertragung statischer Neue Beschreibungsseite 1a (Reinschrift)

Signale. Es hat aber aus heutiger Sicht zwei Nachteile: Eine vollständige Integration in siliziumbasierte CMOS (Complementary metal-oxide-semiconductor)-Technologien ist derzeitig nicht möglich, weil besondere Halbleitermaterialen erforderlich sind und die damit derzeitig erreichbare Zuverlässigkeit für Applikationen mit hohen Qualitätsanforderungen nicht ausreicht.

Magnetische Isolatoren beruhen in der Regel auf dem Transformatorprinzip. Der Sender koppelt sein Signal in die Primärseite ein und der Empfänger koppelt es an der Sekundärseite wieder aus. Primär- und Sekundärwicklungen des Transformators sind galvanisch getrennt. Aus diesem Prinzip ergibt sich, dass statische Signale nicht direkt übertragen werden können. Eine zuverlässige Übertragung erfordert ein in geeigneter Weise moduliertes Trägersignal. Dieser Ansatz ist in Standard-CMOS-Technologien integrierbar. Weniger gebräuchliche magnetische Prinzipien nutzen den Hall-Effekt oder den magnetoresistiven Effekt für eine magnetische Isolation. Eine Sonderstellung nimmt hier die elektromagnetische Isolation ein, die für die galvanische Trennung integrierte Transformatoren und integrierte, verteilte Kapazitäten benutzt.

Kapazitive Isolatoren beruhen auf dem Prinzip der Wechselstrom-Kopplung. Es wird ein hinreichend spannungsfester Kondensator als Koppelelement zwischen Sender und Empfänger benutzt. Dabei dient das Dielektrikum des Kondensators als galvanische Trennung zwischen Sender und Empfänger. Auch hier erfordert eine zuverlässige Übertragung ein in geeigneter Weise moduliertes Trägersignal.

Die meisten Isolatoren müssen, sofern sie prinzipiell keine statischen Signale direkt übertragen können, die zu übertragende Information auf ein Trägersignal modulieren. Die gängigste Methode ist das On-Off-Keying (OOK). Dabei wird das Trägersignal datenabhängig übertragen oder völlig blockiert. Um eine robuste Signalübertragung bei großen Gleichtaktstörungen zu gewährleisten, wird die Übertragungsstrecke meistens differenziell aufgebaut. Weniger häufig findet man das allgemeinere Amplitude-Shift-Keying (ASK) als Modulationsverfahren. Dabei wird die Amplitude des Trägers datenabhängig variiert, jedoch verschwindet das Trägersignal nicht. Weil ASK weniger robust gegen Störungen ist als OOK, wird es für galvanisch getrennte Signalübertragungen nur selten genutzt.

### Offenbarung der Erfindung

Erfindungsgemäß wird eine Detektorschaltung zur galvanisch-getrennten Übertragung digitaler Signale zur Verfügung gestellt, umfassend
- zwei differentielle Signaleingänge,
- einen Eingangsgleichtaktspannungsanschluss,
- eine Wechselspannnungskopplung,
- eine Differenzstufe,
- einen Betriebsspannungsanschluss,
- einen Betriebsmasseanschluss,
- einen Signalausgang,
- einen Bias-Stromanschluss,

wobei die Wechselspannungskopplung zwei Kondensatoren und zwei Widerstände umfasst, und wobei je ein Kondensator auf einer ersten Seite an je einen der differentiellen Signaleingänge angeschlossen ist, und wobei die zweiten Seiten der beiden Kondensatoren jeweils mit der Differenzstufe und über je einen Widerstand mit dem Eingangsgleichtaktspannungsanschluss verbunden sind,
wobei die Differenzstufe einen ersten n-Kanal-Transistor und einen zweiten n-Kanal-Transistor umfasst, und der erste und der zweite n-Kanal-Transistor jeweils mit je einem Widerstand und je einem Kondensator der Wechselspannungskopplung verbunden sind, wobei der Betriebsmasseanschluss mit einem dritten n-Kanal-Transistor verbunden ist, dadurch gekennzeichnet, dass die Detektorschaltung weiter eine Gleichrichterstufe aufweist,
wobei der Bias-Stromanschluss über den einen dritten n-Kanal-Transistor mit der Differenzstufe verbunden ist, und wobei der Bias-Stromanschluss über einen vierten n-Kanal-Transistor und einen fünften n-Kanal-Transistor mit der Gleichrichterstufe verbunden ist, wobei der Betriebsmasseanschluss mit dem vierten und fünften n-Kanal-Transistor verbunden ist,
wobei die Gleichrichterstufe fünf p-Kanal-Transistoren umfasst, und wobei der erste n-Kanal-Transistor mit dem ersten p-Kanal-Transistor, dem vierten p-Kanal-Transistor und dem fünften p-Kanal-Transistor verbunden ist, und wobei der zweite n-Kanal-Transistor mit dem zweiten p-Kanal-Transistor, dem vierten p-Kanal-Transistor und dem fünften p-Kanal-Transistor verbunden ist,
wobei der Betriebsspannungsanschluss mit dem ersten, zweiten und dritten p-Kanal-Transistor verbunden ist,
wobei der Signalausgang mit dem vierten und fünften p-Kanal-Transistor verbunden ist.

Bevorzugte Ausführungsformen sind in den Unteransprüchen 2 bis 6 definiert.

### Vorteile der Erfindung

Die erfindungsgemäße Detektorschaltung kann mit der ersten angelegten Halbwelle des Trägersignals ein entsprechendes Stromsignal ausgeben. Damit ist eine hohe Übertragungsgeschwindigkeit, die im Wesentlichen durch die Trägheit des Stromkomparators bestimmt ist, möglich.

Die Detektorschaltung erlaubt eine nahezu digitale Ansteuerung des vierten und fünften p-Kanal-Transistors der Gleichrichterstufe, wodurch die aktive Gleichrichtung eines Hochfrequenz-Signals robust gegenüber Mismatch innerhalb der Schaltung wird. Außerdem wird problemlos die Demodulation eines OOK-Signals mit einem nachfolgenden Stromkomparator ermöglicht.

Die Differenzstufe unterdrückt Gleichtaktstörungen in hohem Maß. Diese Störunterdrückung wird in erster Näherung nur vom Mismatch des ersten n-Kanal-Transistors und des zweiten n-Kanal-Transistors und vom endlichen Ausgangswiderstand des dritten n-Kanal-Transistors begrenzt.

Es ist unerheblich wie das hochfrequente Differenzsignal an die differentiellen Signaleingänge gelangt, wodurch die erfindungsgemäße Schaltung für kapazitive und magnetische Isolationen gleichermaßen einsetzbar ist.

Das zu den differenziellen Signaleingängen zugehörige Netzwerk aus Kondensatoren und Widerständen bildet eine Wechselstromkopplung mit gleichzeitiger Festlegung der Eingangsgleichtaktspannung. Mit dieser Kopplung kann ein möglicher Offset, der durch Mismatch in der Gleichtaktregelschaltung oder in der galvanischen Trennung selbst verursacht wird, unterdrückt werden. Die Eingangsgleichtaktspannung sollte so gewählt werden, dass Gleichtaktstörungen - also gleichläufige Spannungsänderungen an den differenziellen Signaleingängen - unter keinen Umständen zu einer Verletzung der Sättigungsbedingungen für den zwischen dem Bias-Stromanschluss und den differenziellen Signaleingängen angeordneten dritten n-Kanal-Transistor oder für die Differenzstufe (den ersten und zweiten n-Kanal-Transistor) führt.

Auf diese Weise wird das anliegende Hochfrequenz-Signal vollständig gleichgerichtet und in einen Strom gewandelt. Ein nachfolgender Stromkomparator wandelt das resultierende Stromsignal in ein Digitalsignal. Damit ist die zu übertragende Information empfängerseitig zurückgewonnen.

In einer bevorzugten Ausführungsform sind der erste p-Kanal-Transistor und der zweite p-Kanal-Transistor so eingerichtet, dass sie größere Ströme liefern können, als der erste n-Kanal-Transistor und der zweite n-Kanal-Transistor abnehmen können, wenn kein Differenzsignal an den differentiellen Signaleingängen anliegt. Damit können der erste p-Kanal-Transistor und der zweite p-Kanal-Transistor im linearen Bereich betrieben werden. Die Potenziale von zwischen der Gleichrichterstufe und der Differenzstufe angeordneten Knoten befinden sich dann nahe an der Betriebsspannung AVDD.

Beispielsweise können die Drainströme im ersten n-Kanal-Transistor und im zweiten n-Kanal-Transistor gleich groß und jeweils doppelt so groß wie der am Bias-Stromanschluss anliegende Strom gewählt sein, wenn kein Differenzsignal an den differentiellen Signaleingängen anliegt.

In einer weiteren Ausführungsform sind der erste n-Kanal-Transistor und der zweite n-Kanal-Transistor so eingerichtet, dass sie größere Ströme abnehmen können, als der erste p-Kanal-Transistor und der zweite p-Kanal-Transistor liefern können, wenn ein hochfrequentes Differenzsignal mit hinreichend großer Amplitude an den differentiellen Signaleingängen anliegt. Auch dies stellt sicher, dass die p-Kanal-Transistoren möglichst im linearen Bereich betrieben werden können.

Beispielsweise können Drainströme des ersten p-Kanal-Transistors und des zweiten p-Kanal-Transistors dreimal so groß wie der am Bias-Stromanschluss anliegende Strom, wenn kein Differenzsignal an den differentiellen Signaleingängen anliegt.

Es ist bevorzugt, wenn die Drainströme im ersten n-Kanal-Transistor und im zweiten n-Kanal-Transistor gegenüber den Drainströmen des ersten p-Kanal-Transistors und des zweiten p-Kanal-Transistors ein Verhältnis von 3:2 aufweisen, wenn kein Differenzsignal an den differentiellen Signaleingängen anliegt.

Es ist bevorzugt, wenn die Drainströme im ersten n-Kanal-Transistor und im zweiten n-Kanal-Transistor gegenüber den Drainströmen des ersten p-Kanal-Transistors und des zweiten p-Kanal-Transistors ein Verhältnis von 3:4 aufweisen, wenn ein hochfrequentes Differenzsignal mit hinreichend großer Amplitude an den differentiellen Signaleingängen anliegt.

In einer bevorzugten Ausführungsform wird der Strom aus dem dritten n-Kanal-Transistor vollständig durch den ersten n-Kanal-Transistor oder den zweiten n-Kanal-Transistor geleitet, wenn ein hochfrequentes Differenzsignal mit hinreichend großer Amplitude an den differentiellen Signaleingängen anliegt. Damit reduzieren sich die Potenziale von zwischen der Gleichrichterstufe und der Differenzstufe angeordneten Knoten, da die Drainströme der n-Kanal-Transistoren größer sind als die Drainströme der p-Kanal-Transistoren.

In einer bevorzugten Ausführungsform wird abwechselnd der vierte p-Kanal-Transistor und der fünfte p-Kanal-Transistor durchgesteuert und der jeweils ungenutzte Drainstrom vom ersten p-Kanal-Transistor und dem zweiten p-Kanal-Transistor an den Signalausgang geleitet, wenn ein hochfrequentes Differenzsignal mit hinreichend großer Amplitude an den differentiellen Signaleingängen anliegt. Auf diese Weise wird das anliegende Hochfrequenz-Signal vollständig gleichgerichtet und in einen Strom auf der Empfängerseite gewandelt. Ein nachfolgender Stromkomparator wandelt das resultierende Stromsignal in ein Digitalsignal. Damit ist die zu übertragende Information empfängerseitig zurückgewonnen.

Die Erfindung betrifft weiterhin ein System zur galvanisch getrennten Übertragung digitaler Signale, umfassend eine Senderseite umfassend einen Sender mit einem On-Off-Keying-Modulator, eine Empfängerseite umfassend einen Stromkomparator und eine Detektorschaltung nach einer der vorstehenden Ausführungsformen.

Die galvanisch getrennte Signalübertragung wird mit zwei integrierten Schaltungen, die sich aber in galvanisch getrennten Substraten befinden, realisiert. Parallel zur Empfängerschaltung befindet sich dann eine Gleichtaktregelschaltung. Diese sorgt dafür, dass die Gleichtaktspannung am Empfängereingang immer im zulässigen Bereich liegt, so lange zulässige Werte für die Potenzialdifferenz und ihre Änderungsrate zwischen Sender und Empfänger eingehalten werden.

Der Empfänger besteht aus zwei Teilen, einer Detektorschaltung, die ein Stromsignal ausgibt, wenn ein differenzielles Signal erkannt wird, und einem Komparator für Stromsignale, der das Stromsignal in ein Digitalsignal wandelt.

### Zeichnungen

Ausführungsbeispiele der Erfindung werden anhand der Zeichnungen und der nachfolgenden Beschreibung näher erläutert. Es zeigen:
- Figur 1: eine schematische Darstellung eines erfindungsgemäßen Systems, und
- Figur 2: eine Ausführungsform einer erfindungsgemäßen Detektorschaltung.

### Ausführungsformen der Erfindung

Mit der vorliegenden Erfindung soll eine Detektorschaltung eines Empfängers für eine galvanisch getrennte Signalübertragung bereitgestellt werden. Dabei sollten möglichst viele der folgenden Anforderungen erfüllt werden:
- differentielle Übertragung und hohe Gleichtakt- und Störungsunterdrückung,
- OOK-Modulation,
- kleine Verzögerungszeiten, und
- Eignung für magnetische und kapazitive galvanische Isolation.

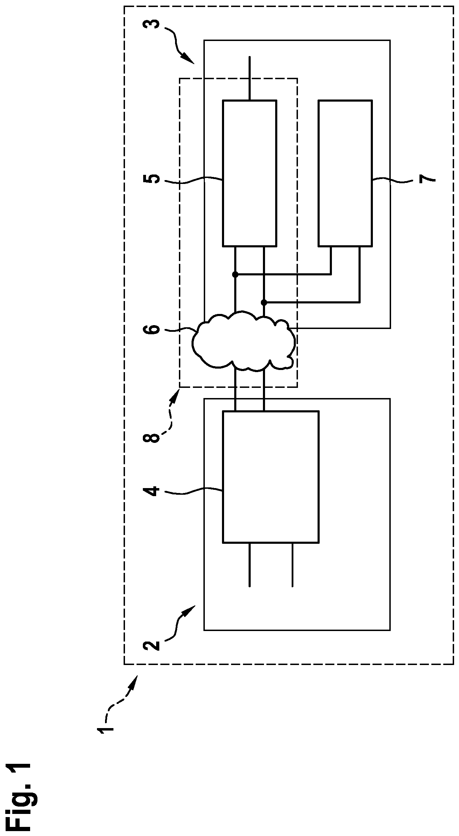

Figur 1 zeigt eine Ausführungsform eines erfindungsgemäßen Systems 1 zur galvanisch getrennten Übertragung digitaler Signale. Das System 1 umfasst eine Senderseite 2 umfassend einen Sender 4 mit einem On-Off-Keying-Modulator, sowie eine Empfängerseite 3 umfassend einen Empfänger 5, einen Stromkomparator 7 und eine Gleichtaktregelschaltung 9. Die erfindungsgemäße Detektorschaltung 8 umfasst den Empfänger 5 und eine galvanische Trennung 6.

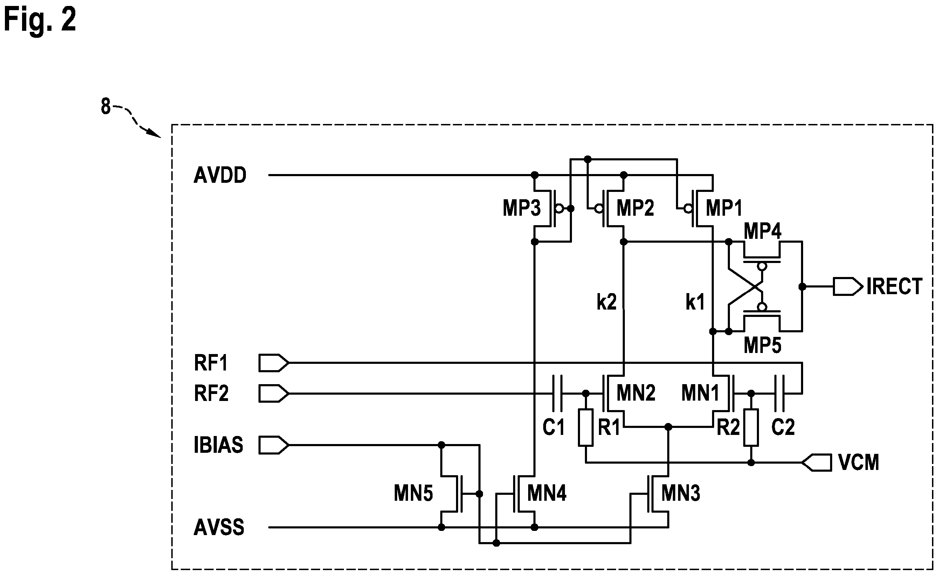

Figur 2 zeigt eine Ausführungsform einer erfindungsgemäßen Detektorschaltung 8 zur galvanisch-getrennten Übertragung digitaler Signale. Die Detektorschaltung umfasst zwei differentielle Signaleingänge RF1, RF2, einen Eingangsgleichtaktspannungsanschluss VCM sowie eine Wechselspannnungskopplung. Die Wechselspannungskopplung umfasst zwei Kondensatoren C1, C2 und zwei Wiederstände R1, R2. Je ein Kondensator C1, C2 ist auf einer ersten Seite an je einen der differentiellen Signaleingänge RF1, RF2 angeschlossen. Die zweiten Seiten der beiden Kondensatoren C1, C2 sind jeweils mit einer Differenzstufe der Detektorschaltung und über je einen Widerstand R1, R2 mit dem Eingangsgleichtaktspannungsanschluss VCM verbunden.

Die Detektorschaltung 8 umfasst weiterhin einen Betriebsspannungsanschluss AVDD, einen Signalausgang IRECT, einen Bias-Stromanschluss IBIAS und eine Gleichrichterstufe. Die Differenzstufe umfasst einen ersten n-Kanal-Transistor MN1 und einen zweiten n-Kanal-Transistor MN2. Der erste und der zweite n-Kanal-Transistor MN1, MN2 sind jeweils mit je einem Widerstand R1, R2 und je einem Kondensator C1, C2 der Wechselspannungskopplung verbunden.

Der Bias-Stromanschluss IBIAS ist über einen dritten n-Kanal-Transistor MN3 mit der Differenzstufe verbunden. Der Bias-Stromanschluss IBIAS ist über einen vierten n-Kanal-Transistor MN4 und einen fünften n-Kanal-Transistor MN5 mit der Gleichrichterstufe verbunden.

Ein Betriebsmasseanschluss AVSS ist mit dem dritten, vierten und fünften n-Kanal-Transistor MN3, MN4, MN5 verbunden.

Die Gleichrichterstufe umfasst fünf p-Kanal-Transistoren MP1, MP2, MP3, MP4, MP5. Der erste n-Kanal-Transistor MN1 ist mit dem ersten p-Kanal-Transistor MP1, dem vierten p-Kanal-Transistor MP4 und dem fünften p-Kanal-Transistor MP5 verbunden. Der zweite n-Kanal-Transistor MN2 ist mit dem zweiten p-Kanal-Transistor MP2, dem vierten p-Kanal-Transistor MP4 und dem fünften p-Kanal-Transistor MP5 verbunden.

Der Betriebsspannungsanschluss AVDD ist mit dem ersten, zweiten und dritten p-Kanal-Transistor MP1, MP2, MP3 verbunden.

Der Signalausgang IRECT ist mit dem vierten und fünften p-Kanal-Transistor MP4, MP5 verbunden.

Die Drainströme im ersten n-Kanal-Transistor MN1 und im zweiten n-Kanal-Transistor MN2 sind gleich groß und jeweils doppelt so groß wie der am Bias-Stromanschluss IBIAS anliegende Strom (I_{DS,MN1} = I_{DS,MN2} = 2 I_{BIAS}), wenn kein Differenzsignal an den differentiellen Signaleingängen RF1, RF2 anliegt. Die Drainströme des dritten p-Kanal-Transistors MP3 und des vierten p-Kanal-Transistors MP4 sind dreimal so groß wie der am Bias-Stromanschluss IBIAS anliegende Strom (I_{DS,MP3} = I_{DS,MP4} = 3 I_{BIAS}), wenn kein Differenzsignal an den differentiellen Signaleingängen RF1, RF2 anliegt.

Der Strom aus dem dritten n-Kanal-Transistor MN3 (IDS,MN3 = 4 IBIAS) wird vollständig durch den ersten n-Kanal-Transistor MN1 oder den zweiten n-Kanal-Transistor MN2 geleitet, wenn ein hochfrequentes Differenzsignal mit hinreichend großer Amplitude an den differentiellen Signaleingängen RF1, RF2 anliegt. Es wird dann zeitweilig das entsprechende Potenzial an Knoten k1 oder k2 der Detektorschaltung 8 reduziert, da die Drainströme der n-Kanal-Transistoren größer sind als die Drainströme der p-Kanal-Transistoren (I_{DS,MNx} > I_{DS,MPx}, x=1,2).

Der vierte p-Kanal-Transistor MP4 und der fünfte p-Kanal-Transistor MP5 wird abwechselnd durchgesteuert und der jeweils ungenutzte Drainstrom wird vom ersten p-Kanal-Transistor MP1 und dem zweiten p-Kanal-Transistor MP2 an den Signalausgang IRECT geleitet, wenn ein hochfrequentes Differenzsignal mit hinreichend großer Amplitude an den differentiellen Signaleingängen RF1, RF2 anliegt.

Es ergeben sich vor allem die folgenden vier Vorteile durch die erfindungsgemäße Lösung:
1. Die beschriebene Detektorschaltung 8 gibt mit der ersten angelegten Halbwelle des Trägersignals ein entsprechendes Stromsignal aus. Damit ist eine hohe Übertragungsgeschwindigkeit, die im Wesentlichen durch die Trägheit des Stromkomparators 7 bestimmt ist, möglich.
2. Durch die nahezu digitale Ansteuerung des vierten p-Kanal-Transistors MP4 und des fünften p-Kanal-Transistors MP5 wird die aktive Gleichrichtung des Hochfrequenz-Signals robust gegenüber einem Mismatch innerhalb der Detektorschaltung 8 und erlaubt problemlos die Demodulation eines OOK-Signals mit dem nachfolgenden Stromkomparator 7.
3. Die Differenzstufe unterdrückt Gleichtaktstörungen in hohem Maß. Diese Störunterdrückung wird in erster Näherung nur vom Mismatch zwischen dem ersten n-Kanal-Transistor MN1 und dem zweiten n-Kanal-Transistor MN2 und vom endlichen Ausgangswiderstand des dritten n-Kanal-Transistors MN3 begrenzt.
4. Es ist unerheblich, wie das hochfrequente Differenzsignal an die differentiellen Signaleingänge RF1, RF2 gelangt, wodurch der Empfänger 5 für kapazitive und magnetische Isolationen gleichermaßen einsetzbar ist.

Besonders die Vorteile 2 und 3 unterscheiden die erfindungsgemäße Lösung von denen im Stand der Technik.

## Patentansprüche

1. Detektorschaltung (8) zur galvanisch-getrennten Übertragung digitaler Signale, umfassend
- zwei differentielle Signaleingänge (RF1, RF2),
- einen Eingangsgleichtaktspannungsanschluss (VCM),
- eine Wechselspannnungskopplung,
- eine Differenzstufe,
- einen Betriebsspannungsanschluss (AVDD),
- einen Betriebsmasseanschluss (AVSS),
- einen Signalausgang (IRECT),
- einen Bias-Stromanschluss (IBIAS),
wobei die Wechselspannungskopplung zwei Kondensatoren (C1, C2) und zwei Wiederstände (R1, R2) umfasst, und wobei je ein Kondensator (C1, C2) auf einer ersten Seite an je einen der differentiellen Signaleingänge (RF1, RF2) angeschlossen ist, und wobei die zweiten Seiten der beiden Kondensatoren (C1, C2) jeweils mit der Differenzstufe und über je einen Widerstand (R1, R2) mit dem Eingangsgleichtaktspannungsanschluss (VCM) verbunden sind,
wobei die Differenzstufe einen ersten n-Kanal-Transistor (MN1) und einen zweiten n-Kanal-Transistor (MN2) umfasst, und der erste und der zweite n-Kanal-Transistor (MN1, MN2) jeweils mit je einem Widerstand (R1, R2) und je einem Kondensator (C1, C2) der Wechselspannungskopplung verbunden sind,
wobei der Betriebsmasseanschluss (AVSS) mit einem dritten n-Kanal-Transistor (MN3) verbunden ist, **dadurch gekennzeichnet, dass** die Detektorschaltung (8) weiter eine Gleichrichterstufe aufweist,
wobei der Bias-Stromanschluss (IBIAS) über den dritten n-Kanal-Transistor (MN3) mit der Differenzstufe verbunden ist, und wobei der Bias-Stromanschluss (IBIAS) über einen vierten n-Kanal-Transistor (MN4) und einen fünften n-Kanal-Transistor (MN5) mit der Gleichrichterstufe verbunden ist,
wobei der Betriebsmasseanschluss (AVSS) mit dem vierten und fünften n-Kanal-Transistor (MN4, MN5) verbunden ist,
wobei die Gleichrichterstufe fünf p-Kanal-Transistoren (MP1, MP2, MP3, MP4, MP5) umfasst, und wobei der erste n-Kanal-Transistor (MN1) mit dem ersten p-Kanal-Transistor (MP1), dem vierten p-Kanal-Transistor (MP4) und dem fünften p-Kanal-Transistor (MP5) verbunden ist, und wobei der zweite n-Kanal-Transistor (MN2) mit dem zweiten p-Kanal-Transistor (MP2), dem vierten p-Kanal-Transistor (MP4) und dem fünften p-Kanal-Transistor (MP5) verbunden ist,
wobei der Betriebsspannungsanschluss (AVDD) mit dem ersten, zweiten und dritten p-Kanal-Transistor (MP1, MP2, MP3) verbunden ist,
wobei der Signalausgang (IRECT) mit dem vierten und fünften p-Kanal-Transistor (MP4, MP5) verbunden ist.

2. Detektorschaltung (8) nach Anspruch 1, wobei der erste p-Kanal-Transistor (MP1) und der zweite p-Kanal-Transistor (MP2) so eingerichtet sind, dass sie größere Ströme liefern können, als der erste n-Kanal-Transistor (MN1) und der zweite n-Kanal-Transistor (MN2) abnehmen können, wenn kein Differenzsignal an den differentiellen Signaleingängen (RF1, RF2) anliegt.

3. Detektorschaltung (8) nach Anspruch 1 oder 2, wobei der erste N-Kanal-Transistor (MN1) und der zweite N-Kanal-Transistor (MN2) so eingerichtet sind, dass sie größere Ströme abnehmen können, als der erste p-Kanal-Transistor (MP1) und der zweite p-Kanal-Transistor (MP2) liefern können, wenn ein hochfrequentes Differenzsignal mit einer Amplitude oberhalb einer Schwelle an den differentiellen Signaleingängen (RF1, RF2) anliegt.

4. Detektorschaltung (8) nach einem der vorstehenden Ansprüche, wobei der Drainstrom aus dem dritten n-Kanal-Transistor (MN3) vollständig durch den ersten n-Kanal-Transistor (MN1) oder den zweiten n-Kanal-Transistor (MN2) geleitet wird, wenn ein hochfrequentes Differenzsignal mit einer Amplitude oberhalb einer Schwelle Z an den differentiellen Signaleingängen (RF1, RF2) anliegt.

5. Detektorschaltung (8) nach Anspruch 4, wobei abwechselnd der vierte p-Kanal-Transistor (MP4) und der fünfte p-Kanal-Transistor (MP5) durchgesteuert wird und den jeweils ungenutzten Drainstrom vom ersten p-Kanal-Transistor (MP1) und dem zweiten p-Kanal-Transistor (MP2) an den Signalausgang (IRECT) geleitet wird, wenn ein hochfrequentes Differenzsignal mit einer Amplitude oberhalb einer Schwelle an den differentiellen Signaleingängen (RF1, RF2) anliegt.

6. System (1) zur galvanisch getrennten Übertragung digitaler Signale, umfassend
- eine Senderseite (2) umfassend einen Sender (4) mit einem On-Off-Keying-Modulator,
- eine Empfängerseite (3) umfassend einen Stromkomparator (7), eine Gleichtaktregelschaltung und eine Detektorschaltung (8) nach einem der vorstehenden Ansprüche.

## Claims

1. Detector circuit (8) for the galvanically isolated transmission of digital signals, comprising
- two differential signal inputs (RF1, RF2),
- an input common-mode voltage connection (VCM),
- an AC voltage coupling,
- a differential stage,
- an operating voltage connection (AVDD),
- an operating earth connection (AVSS),
- a signal output (IRECT),
- a bias current connection (IBIAS),
wherein the AC voltage coupling comprises two capacitors (C1, C2) and two resistors (R1, R2), and wherein a respective capacitor (C1, C2) is connected on a first side to a respective one of the differential signal inputs (RF1, RF2), and wherein the second sides of the two capacitors (C1, C2) are each connected to the differential stage and, via a respective resistor (R1, R2), to the input common-mode voltage connection (VCM), wherein the differential stage comprises a first n-channel transistor (MN1) and a second n-channel transistor (MN2), and the first and the second n-channel transistor (MN1, MN2) are each connected to a respective resistor (R1, R2) and a respective capacitor (C1, C2) of the AC voltage coupling,
wherein the operating earth connection (AVSS) is connected to a third n-channel transistor (MN3), **characterized in that** the detector circuit (8) also has a rectifier stage, wherein the bias current connection (IBIAS) is connected to the differential stage via the third n-channel transistor (MN3), and wherein the bias current connection (IBIAS) is connected to the rectifier stage via a fourth n-channel transistor (MN4) and a fifth n-channel transistor (MN5),
wherein the operating earth connection (AVSS) is connected to the fourth and fifth n-channel transistors (MN4, MN5),
wherein the rectifier stage comprises five p-channel transistors (MP1, MP2, MP3, MP4, MP5), and wherein the first n-channel transistor (MN1) is connected to the first p-channel transistor (MP1), the fourth p-channel transistor (MP4) and the fifth p-channel transistor (MP5), and wherein the second n-channel transistor (MN2) is connected to the second p-channel transistor (MP2), the fourth p-channel transistor (MP4) and the fifth p-channel transistor (MP5),
wherein the operating voltage connection (AVDD) is connected to the first, second and third p-channel transistors (MP1, MP2, MP3),
wherein the signal output (IRECT) is connected to the fourth and fifth p-channel transistors (MP4, MP5).

2. Detector circuit (8) according to Claim 1, wherein the first p-channel transistor (MP1) and the second p-channel transistor (MP2) are designed in such a way that they can deliver larger currents than the first n-channel transistor (MN1) and the second n-channel transistor (MN2) can take up when there is no differential signal present at the differential signal inputs (RF1, RF2).

3. Detector circuit (8) according to Claim 1 or 2, wherein the first n-channel transistor (MN1) and the second n-channel transistor (MN2) are designed in such a way that they can take up larger currents than the first p-channel transistor (MP1) and the second p-channel transistor (MP2) can deliver when a high-frequency differential signal with an amplitude above a threshold is present at the differential signal inputs (RF1, RF2).

4. Detector circuit (8) according to one of the preceding claims, wherein the drain current from the third n-channel transistor (MN3) is conducted completely through the first n-channel transistor (MN1) or the second n-channel transistor (MN2) when a high-frequency differential signal with an amplitude above a threshold is present at the differential signal inputs (RF1, RF2).

5. Detector circuit (8) according to Claim 4, wherein the fourth p-channel transistor (MP4) and the fifth p-channel transistor (MP5) are turned on alternately and the unused drain current in each case is conducted from the first p-channel transistor (MP1) and the second p-channel transistor (MP2) to the signal output (IRECT) when a high-frequency differential signal with an amplitude above a threshold is present at the differential signal inputs (RF1, RF2).

6. System (1) for the galvanically isolated transmission of digital signals, comprising
- a transmitter side (2) comprising a transmitter (4) with an on-off keying modulator,
- a receiver side (3) comprising a current comparator (7), a common-mode control circuit and a detector circuit (8) according to one of the preceding claims.

## Revendications

1. Circuit détecteur (8) destiné à la transmission avec séparation galvanique de signaux numériques, comprenant
- deux entrées de signal différentielles (RF1, RF2),
- une borne de tension de mode commun d'entrée (VCM),
- un couplage de tension alternative,
- un étage différentiel,
- une borne de tension de fonctionnement (AVDD),
- une borne de masse de fonctionnement (AVSS),
- une sortie de signal (IRECT),
- une borne de courant de polarisation (IBIAS),
le couplage de tension alternative comprenant deux condensateurs (C1, C2) et deux résistances (R1, R2), et respectivement un condensateur (C1, C2) étant connecté sur un premier côté à respectivement une des entrées de signal différentielles (RF1, RF2), et les deux côtés des deux condensateurs (C1, C2) étant respectivement reliés à l'étage différentiel et par respectivement une résistance (R1, R2) à la borne de tension de mode commun d'entrée (VCM),
l'étage différentiel comprenant un premier transistor de canal n (MN1) et un deuxième transistor de canal n (MN2), et le premier et le deuxième transistor de canal n (MN1, MN2) étant reliés respectivement à une résistance (R1, R2) respective et à un condensateur (C1, C2) respectif du couplage de tension alternative,
la borne de masse de fonctionnement (AVSS) étant reliée à un troisième transistor de canal n (MN3),
**caractérisé en ce que** le circuit détecteur (8) présente en outre un étage de redresseur,
la borne de courant de polarisation (IBIAS) étant reliée à l'étage différentiel par l'intermédiaire du troisième transistor de canal n (MN3), et la borne de courant de polarisation (IBIAS) étant reliée à l'étage de redresseur par l'intermédiaire d'un quatrième transistor de canal n (MN4) et d'un cinquième transistor de canal n (MN5),
la borne de masse de fonctionnement (AVSS) étant reliée au quatrième et au cinquième transistor de canal n (MN4, MN5),
l'étage de redresseur comprenant cinq transistors de canal p (MP1, MP2, MP3, MP4, MP5), et le premier transistor de canal n (MN1) étant relié au premier transistor de canal p (MP1), au quatrième transistor de canal p (MP4) et au cinquième transistor de canal p (MP5), et le deuxième transistor de canal n (MN2) étant relié au deuxième transistor de canal p (MP2), au quatrième transistor de canal p (MP4) et au cinquième transistor de canal p (MP5),
la borne de tension de fonctionnement (AVDD) étant reliée au premier, au deuxième et au troisième transistor de canal p (MP1, MP2, MP3),
la sortie de signal (IRECT) étant reliée au quatrième et au cinquième transistor de canal p (MP4, MP5) .

2. Circuit détecteur (8) selon la revendication 1, dans lequel le premier transistor de canal p (MP1) et le deuxième transistor de canal p (MP2) sont aménagés de telle sorte qu'ils peuvent fournir des courants plus importants que ce que le premier transistor de canal n (MN1) et le deuxième transistor de canal n (MN2) peuvent absorber quand aucun signal de différence n'est appliqué aux entrées de signal différentielles (RF1, RF2).

3. Circuit détecteur (8) selon la revendication 1 ou 2, dans lequel le premier transistor de canal N (MN1) et le deuxième transistor de canal N (MN2) sont aménagés de telle sorte qu'ils peuvent absorber des courants plus importants que ce que le premier transistor de canal p (MP1) et le deuxième transistor de canal p (MP2) peuvent fournir quand un signal de différence haute fréquence d'une amplitude au-dessus d'un seuil est appliqué aux entrées de signal différentielles (RF1, RF2).

4. Circuit détecteur (8) selon l'une quelconque des revendications précédentes, dans lequel le courant de drain provenant du troisième transistor de canal n (MN3) est guidé entièrement à travers le premier transistor de canal n (MN1) ou le deuxième transistor de canal n (MN2) quand un signal de différence haute fréquence d'une amplitude au-dessus d'un seuil est appliqué aux entrées de signal différentielles (RF1, RF2).

5. Circuit détecteur (8) selon la revendication 4, dans lequel en alternance le quatrième transistor de canal p (MP4) et le cinquième transistor de canal p (MP5) sont passants, et le courant de drain respectivement non utilisé est conduit du premier transistor de canal p (MP1) et du deuxième transistor de canal p (MP2) à la sortie de signal (IRECT) quand un signal de différence haute fréquence d'une amplitude au-dessus d'un seuil est appliqué aux entrées de signal différentielles (RF1, RF2).

6. Système (1) destiné à la transmission avec séparation galvanique de signaux numérique, comprenant
- un côté émetteur (2) comprenant un émetteur (4) doté d'un modulateur tout ou rien,
- un côté récepteur (3) comprenant un comparateur de courant (7), un circuit de régulation de mode commun et un circuit détecteur (8) selon l'une quelconque des revendications précédentes.
